# FASCICULE DE BREVET EUROPEEN

(11) **EP 0 787 347 B1**
(45) Date de publication et mention de la délivrance du brevet: **14.04.1999**
(21) Numéro de dépôt: 95935971.2
(22) Date de dépôt: 17.10.1995
(51) Int. Cl.: H01B 1/22

(54) **ENCRE CONDUCTRICE COMPRENANT DES GRAINS METALLIQUES AYANT DES POINTS DE FUSION DIFFERENTS**
LEITFÄHIGE TINTE MIT METALLISCHEN PERLEN VON ABWEICHENDEN SCHMELZPUNKTEN
ELECTRICALLY CONDUCTING INK WITH METAL GRAINS OF DIFFERENT MELTING POINTS

(30) Priorité: 19.10.1994 FR 9412470
(43) Date de publication de la demande: 06.08.1997
(73) Titulaire: SCHLUMBERGER Systèmes, 92120 Montrouge (FR)
(72) Inventeur: GAUMET, Michel, F-45560 Saint-Denis-en-Val (FR)
(74) Mandataire: Fruchard, Guy
(86) Numéro de dépôt international: FR9501365
(87) Numéro de publication internationale: WO9613041

(56) Documents cités:
- DE-A- 4 218 173

## Description

La présente invention concerne un procédé pour relier une piste conductrice sur un substrat en matière plastique à un fil conducteur ou à une autre piste conductrice ainsi qu'une jonction correspondante.

On utilise actuellement des encres conductrices pour la réalisation de pistes conductrices sur des supports isolants variés, notamment sur des films ou des feuilles de matière plastique entrant dans la constitution des cartes électroniques.

Avant application, ces encres comportent des grains métalliques, généralement des grains d'argent dont le point de fusion est élevé, qui sont dispersés dans une matière organique en phase liquide. Lors de l'application, l'encre est portée à une température provoquant le durcissement de la matière organique qui relie les grains métalliques entre eux avec ou sans évaporation d'une partie de la phase liquide. La température d'application est généralement de l'ordre de 70°C.

En raison de la température de fusion élevée des grains métalliques, il est très difficile de provoquer une fusion locale de l'encre conductrice pour la liaison avec un composant après dépôt de l'encre conductrice, ou pour relier entre elles deux pistes conductrices de constitution différente réalisées l'une après l'autre sur un même substrat. Une température élevée susceptible de provoquer la fusion des grains métalliques provoquerait la détérioration du substrat qui est généralement réalisé en une matière plastique ayant un point de fusion inférieur au point de fusion des grains métalliques. Les encres actuelles entraînent donc la formation de liaisons électriques souvent défectueuses même lorsqu'une piste réalisée en encre conductrice est en contact physique avec un composant ou avec une autre piste.

On connaît par ailleurs du document DE-A-4218173 une résine rendue conductrice par des grains métalliques à haut point de fusion enrobés dans un métal à point de fusion plus faible, et destinée à réaliser des boîtiers conducteurs pour des composants électroniques. L'enseignement de ce document n'est en aucune façon transposable au domaine particulier des pistes conductrices réalisées sur un substrat en matière plastique.

La présente invention a pour objet un procédé permettant la réalisation d'une liaison électrique satisfaisante avec un composant ou une autre piste sans détérioration notable du substrat.

Selon l'invention on propose un procédé pour relier une piste conductrice sur un substrat en matière plastique à un fil conducteur, comprenant les étapes d'appliquer sur le substrat une encre conductrice comprenant des premiers et des seconds grains métalliques dispersés dans une matière organique, les seconds grains métalliques ayant une température de fusion comprise entre la température de fusion des premiers grains métalliques et une température de durcissement de la matière organique, de chauffer l'encre conductrice entre la température de durcissement de la matière organique et une température de fusion des seconds grains métalliques pour former la piste conductrice, de placer le fil conducteur sur la piste conductrice, et de chauffer localement le fil conducteur et la piste conductrice à une température comprise entre les températures de fusion des premiers et seconds grains métalliques jusqu'à ce que les seconds grains métalliques soient fondus.

Ainsi, lors de l'application de l'encre conductrice les premiers et seconds grains métalliques restent à l'état solide et, lors de l'échauffement local de l'encre conductrice et du fil conducteur à une température égale à la température de fusion des seconds grains métalliques on obtient une fusion des seconds grains métalliques réalisant une liaison conductrice efficace avec le fil conducteur. A ce propos on notera que les seconds grains métalliques étant intercalés entre les premiers grains métalliques et chauffés de façon ponctuelle l'opération de soudage peut être réalisée suffisamment rapidement pour éviter de transmettre au substrat une quantité de chaleur qui provoquerait sa détérioration.

Selon l'invention, on propose également un procédé de liaison d'une première et d'une seconde pistes conductrices sur un substrat en matière plastique, comprenant les étapes de réaliser successivement la première et la seconde piste conductrice sur le substrat en matière plastique en appliquant sur le substrat une encre conductrice comprenant des premiers et des seconds grains métalliques dispersés dans une matière organique, les seconds grains métalliques ayant une température de fusion comprise entre la température de fusion des premiers grains métalliques et une température de durcissement de la matière organique, de chauffer l'encre conductrice entre la température de durcissement de la matière organique et une température de fusion des seconds grains métalliques pour former une piste conductrice, de chauffer localement la première et la seconde pistes conductrices dans une zone de jonction de la première et la seconde pistes conductrices à une température comprise entre les températures de fusion des premiers et seconds grains métalliques jusqu'à ce que les seconds grains métalliques soient fondus.

L'invention concerne en outre, une jonction entre une première piste conductrice sur un substrat en matière plastique et un fil conducteur ou une seconde piste conductrice, la jonction comprenant des premiers grains métalliques noyés dans une masse d'un second métal ayant une température de fusion qui est inférieure à une température de fusion des premiers grains métalliques tandis qu'au voisinage de la jonction au moins la première piste conductrice comporte des premiers et des seconds grains métalliques noyés dans un polymère.

Par ailleurs, le volume occupé par les grains métalliques empilés à l'état solide est supérieur au volume du métal correspondant à l'état fondu. Le volume total d'un segment de piste après fusion des seconds grains métalliques est donc inférieur au volume total de la piste avant une opération de soudage. On a constaté que cette diminution de volume provoque des contraintes de cisaillement importantes dans le corps de l'encre conductrice.

Selon un aspect important de l'invention on minimise la création des contraintes en prévoyant un volume du second métal compris entre 10 et 40 %, et de préférence entre 10 et 20 %, du volume total du métal. On minimise ainsi la réduction de volume lors d'une fusion des seconds grains métalliques. Cette réduction de volume est alors compensée par l'insertion des pièces à relier à la piste conductrice ou par l'interpénétration des extrémités de deux pistes reliées entre elles.

Selon un autre aspect de l'invention les premiers et seconds grains métalliques ont des dimensions sensiblement égales. On évite ainsi qu'après transport et stockage les premiers et seconds grains métalliques ne se répartissent selon des couches séparées au moment de l'application de l'encre.

D'autres caractéristiques et avantages de l'invention apparaîtront à la lecture de la description non limitative qui suit, en relation avec les figures parmi lesquelles:
- la figure 1 est une vue en coupe d'une piste conductrice réalisée au moyen d'une encre selon l'invention,
- la figure 2 est une vue en coupe partielle analogue à celle de la figure 1 après insertion d'un fil dans la piste conductrice.

D'une façon connue en soi l'encre conductrice selon l'invention comporte des premiers grains métalliques dispersés dans une matière organique en phase liquide. Les premiers grains métalliques sont par exemple en argent et la matière organique est par exemple une résine de type époxy ou polyester. Selon l'invention l'encre conductrice comporte également des seconds grains métalliques dispersés dans la matière organique, ces seconds grains métalliques ayant une température de fusion comprise entre la température de fusion des premiers grains métalliques et la température de durcissement de la matière organique. Ces seconds grains métalliques sont par exemple réalisés en un métal choisi dans le groupe comprenant le plomb, l'antimoine, le zinc, l'étain, un alliage d'au moins un de ces métaux, ou un alliage d'au moins un de ces métaux et de sélénium.

De préférence le point de fusion des premiers grains métalliques est supérieur à 900°C tandis que le point de fusion des seconds grains métalliques est situé dans la plage allant de 200 à 430 °C. Le métal constituant le second grain métallique est choisi de préférence pour avoir vis-à-vis des premiers grains métalliques une bonne mouillabilité à l'état fondu.

Afin d'éviter que les premiers et seconds grains ne se rangent selon des couches séparées lors du stockage ou du transport ainsi que lors de l'application de l'encre conductrice, les premiers et seconds grains métalliques ont de préférence des dimensions sensiblement égales, de préférence comprises entre 0,6 et 6 µm. En raison de la densité très voisine des métaux constituant les différents grains une répartition au hasard des grains est alors obtenue simplement en agitant le récipient contenant l'encre conductrice avant son application.

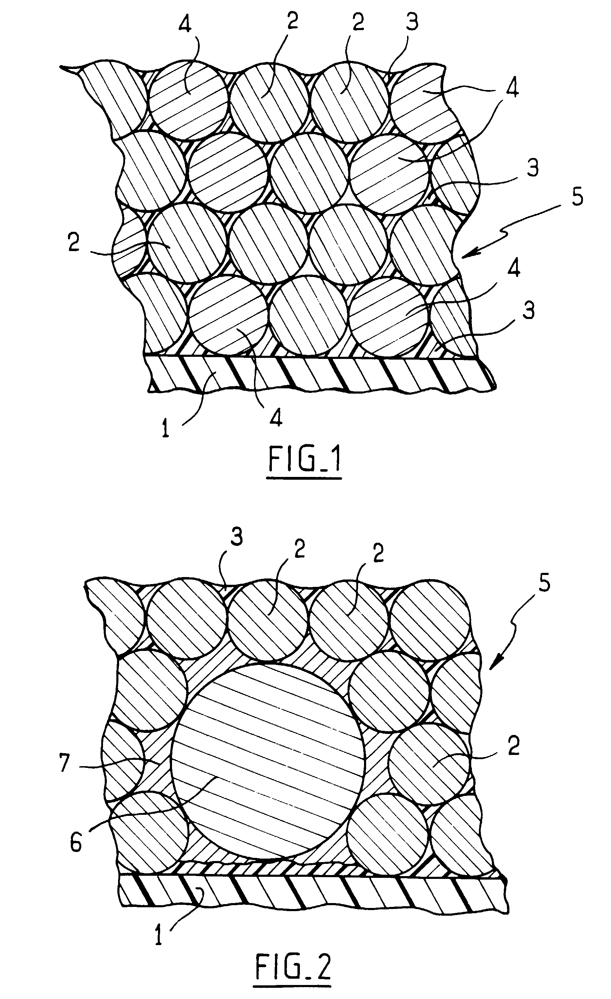

L'encre conductrice selon l'invention est appliquée à une température inférieure à la température de fusion des seconds grains métalliques, par exemple une température de 70°C, afin d'obtenir le durcissement de la matière organique, soit par polymérisation soit par simple évaporation d'un solvant. Après application de l'encre conductrice selon l'invention sur un substrat 1, par exemple un substrat en matière plastique, on obtient une piste conductrice telle qu'illustrée sur la figure 1 dans laquelle les premiers grains métalliques 2 sont liés par la matière organique durcie 3, et les seconds grains métalliques 4 sont intercalés entre les premiers grains métalliques 2 et sont également liés à ceux-ci par la matière organique 3, les différents grains métalliques étant en contact les uns avec les autres. La piste conductrice continue, généralement désignée en 5, ainsi obtenue présente donc une excellente conductivité.

Lorsque l'on souhaite fixer un fil conducteur 6 sur la piste conductrice 5, le fil conducteur 6 est posé sur la piste conductrice puis chauffé à une température supérieure à la température de fusion des seconds grains métalliques. Les grains métalliques sont ainsi chauffés jusqu'à ce que les seconds grains métalliques 4 soient fondus. La matière organique est alors ramollie de sorte que les premiers grains métalliques sont désolidarisés les uns des autres et permettent le passage du fil conducteur 6. Après refroidissement le fil conducteur 6 est relié aux premiers grains métalliques adjacents 2 par une masse métallique conductrice 7 résultant du retour à l'état solide des seconds grains métalliques 4 comme illustré par la figure 2. On obtient ainsi une excellente conductivité de la liaison même si quelques particules de matière organique se trouvent dispersées dans la masse métallique résultant des seconds grains fondus.

Dans le cas d'une jonction entre deux pistes, la fusion de l'encre conductrice selon l'invention est réalisée dans la zone de jonction des deux pistes de sorte que les seconds grains métalliques qui sont localement fondus assurent une liaison entre les premiers grains métalliques des deux pistes adjacentes.

On remarquera que lors de l'opération de soudage une partie de la matière organique est brûlée ou sublimée sous l'effet de la chaleur et le métal liquide obtenu par fusion des seconds grains métalliques tend à remplir les interstices entre les premiers grains métalliques. Afin de minimiser la réduction de volume de la piste conductrice résultant de l'opération de soudage, on prévoit selon l'invention que les seconds grains métalliques ne représentent qu'un volume compris entre 10 et 40 %, et de préférence entre 10 et 20 % du volume total des grains métalliques, en particulier lorsque l'encre conductrice conforme à l'invention doit être utilisée pour former une piste conductrice réalisant un contact électrique avec une surface métallique.

Bien entendu l'invention n'est pas limitée au mode de réalisation décrit et on peut y apporter des variantes de réalisation sans sortir du cadre de l'invention tel que défini par les revendications.

En particulier, bien que les grains métalliques de l'encre conductrice selon l'invention aient été illustrés sur les figures sous forme de grains sphériques, ils pourront avoir toute forme appropriée.

## Revendications

1. Procédé pour relier une piste conductrice (5) sur un substrat en matière plastique (1) à un fil conducteur (6), caractérisé en ce qu'il comprend les étapes d'appliquer sur le substrat (1) une encre conductrice comprenant des premiers (2) et des seconds (4) grains métalliques dispersés dans une matière organique (3), les seconds grains métalliques (4) ayant une température de fusion comprise entre la température de fusion des premiers grains métalliques (2) et une température de durcissement de la matière organique, de chauffer l'encre conductrice entre la température de durcissement de la matière organique et une température de fusion des seconds grains métalliques (4) pour former la piste conductrice, de placer le fil conducteur (6) sur la piste conductrice, et de chauffer localement le fil conducteur et la piste conductrice à une température comprise entre les températures de fusion des premiers et seconds grains métalliques jusqu'à ce que les seconds grains métalliques soient fondus.

2. Procédé de liaison d'une première et d'une seconde pistes conductrices sur un substrat en matière plastique, caractérisé en ce qu'il comprend les étapes de réaliser successivement la première et la seconde piste conductrice sur le substrat en matière plastique en appliquant sur le substrat (1) une encre conductrice comprenant des premiers (2) et des seconds (4) grains métalliques dispersés dans une matière organique (3), les seconds grains métalliques (4) ayant une température de fusion comprise entre la température de fusion des premiers grains métalliques (2) et une température de durcissement de la matière organique, de chauffer l'encre conductrice entre la température de durcissement de la matière organique et une température de fusion des seconds grains métalliques (4) pour former chaque piste conductrice, de chauffer localement la première et la seconde pistes conductrices dans une zone de jonction de la première et la seconde pistes conductrices à une température comprise entre les températures de fusion des premiers et seconds grains métalliques jusqu'à ce que les seconds grains métalliques soient fondus.

3. Jonction entre une première piste conductrice (5) sur un substrat en matière plastique et un fil conducteur (6) ou une seconde piste conductrice, caractérisée en ce que la jonction comprend des premiers grains métalliques (2) noyés dans une masse d'un second métal (7) ayant une température de fusion qui est inférieure à une température de fusion des premiers grains métalliques (2) tandis qu'au voisinage de la jonction au moins la première piste conductrice comporte des premiers (2) et des seconds (4) grains métalliques noyés dans un polymère.

4. Jonction selon la revendication 3, caractérisée en ce que le second métal (4, 7) occupe un volume compris entre 10 % et 40 % du volume total de métal.

5. Jonction selon la revendication 4, caractérisée en ce que le second métal occupe un volume compris entre 10 % et 20 % du volume total du métal.

## Patentansprüche

1. Verfahren zum Verbinden einer Leiterbahn (5) auf einem Substrat aus Kunststoff (1) mit einem Leitungsdraht (6), **gekennzeichnet** durch die Schritte des Auftragens einer leitfähigen Tinte auf das Substrat (1), wobei die leitfähige Tinte erste (2) und zweite (4) in einem organischen Stoff (3) dispergierte metallische Körner umfaßt, wobei die zweiten metallischen Körner (4) eine Schmelztemperatur haben, die zwischen der Schmelztemperatur der ersten metallischen Körner (2) und einer Aushärtetemperatur des organischen Stoffes liegt, des Erwärmens der leitfähigen Tinte auf eine Temperatur, die zwischen der Aushärtetemperatur des organischen Stoffes und einer Schmelztemperatur der zweiten metallischen Körner (4) liegt, um die Leiterbahn auszubilden, des Anordnens des Leitungsdrahtes (6) auf der Leiterbahn und des lokalen Erwärmens des Leitungsdrahtes und der Leiterbahn auf eine Temperatur, die zwischen den Schmelztemperaturen der ersten und der zweiten metallischen Körner liegt, bis die zweiten metallischen Körner geschmolzen sind.

2. Verfahren zum Verbinden einer ersten und einer zweiten Leiterbahn auf einem Substrat aus Kunststoff, **gekennzeichnet** durch die Schritte des nacheinander Erzeugens der ersten und der zweiten Leiterbahn auf dem Substrat aus Kunststoff durch Auftragen einer leitfähigen Tinte auf dem Substrat (1), wobei die leitfähige Tinte erste (2) und zweite (4) in einem organischen Stoff (3) dispergierte metallische Körner umfaßt, wobei die zweiten metallischen Körner (4) eine Schmelztemperatur haben, die zwischen der Schmelztemperatur der ersten metallischen Körner (2) und einer Aushärtetemperatur des organischen Stoffes liegt, des Erwärmens der leitfähigen Tinte auf eine Temperatur, die zwischen der Aushärtetemperatur des organischen Stoffes und einer Schmelztemperatur der zweiten metallischen Körner (4) liegt, um die einzelnen Leiterbahnen auszubilden, des lokalen Erwärmens der ersten und der zweiten Leiterbahn in einer Verbindungszone der ersten und der zweiten Leiterbahn auf eine Temperatur, die zwischen den Schmelztemperaturen der ersten und zweiten metallischen Körner liegt, bis die zweiten metallischen Körner geschmolzen sind.

3. Verbindung zwischen einer ersten Leiterbahn (5) auf einem Substrat aus Kunststoff und einem Leitungsdraht (6) oder einer zweiten Leiterbahn, dadurch **gekennzeichnet**, daß die Verbindung erste metallische Körner (2) hat, die in eine Masse eines zweiten Metalles (7) eingebettet sind, das eine Schmelztemperatur hat, die niedriger als eine Schmelztemperatur der ersten metallischen Körner (2) ist, während in der Nähe der Verbindung mindestens die erste Leiterbahn erste (2) und zweite (4) metallische Körner hat, die in ein Polymer eingebettet sind.

4. Verbindung nach Anspruch 3, dadurch **gekennzeichnet**, daß das zweite Metall (4, 7) ein Volumen hat, das zwischen 10% und 40% des Gesamtvolumens des Metalls ausmacht.

5. Verbindung nach Anspruch 4, dadurch **gekennzeichnet**, daß das zweite Metall ein Volumen hat, das zwischen 10% und 20% des Gesamtvolumens des Metalls ausmacht.

## Claims

1. A method of connecting a conductive wiring (5) on a plastic substrate (1) to a conductive wire (6), characterized in that it comprises the steps of applying to the substrate (1) a conductive ink comprising first (2) and second (4) metal grains dispersed in an organic material (3), said second metal grains (4) having a melting temperature that lies between a melting temperature of the first metal grains (2) and a setting temperature of the organic material, heating the conductive ink between the setting temperature of the organic material and a melting temperature of the second metal grains (4) in order to form the conductive wiring, placing the conductive wire (6) on the conductive wiring, and locally heating the conductive wire and the conductive wiring at a temperature lying between the melting temperatures of first and second metal grains until said second metal grains are fused.

2. A method of connecting a first and second conductive wirings on a plastic substrate, characterized in that it comprises the steps of successively forming the first and second conductive wirings on the plastic substrate by applying to the substrate (1) a conductive ink comprising first (2) and second (4) metal grains dispersed in an organic material (3), said second metal grains (4) having a melting temperature that lies between a melting temperature of the first metal grains (2) and a setting temperature of the organic material, heating the conductive ink between the setting temperature of the organic material and a melting temperature of the second metal grains (4) in order to form each conductive wiring, locally heating the first and second conductive wirings in a junction zone of the first and second conductive wirings at a temperature lying between the melting temperatures of the first and second metal grains until said second metal grains are fused.

3. A junction between a first conductive wiring (5) on a plastic substrate and a conductive wire (6) or a second conductive wiring, characterized in that said junction includes first metal grains (2) embedded in a mass of a second metal (7) having a melting temperature that is lower than a melting temperature of the first metal grains (2) while aside the junction at least the first conductive wiring includes first (2) and second (4) metal grains embedded in a polymer.

4. A junction according to claim 13, characterized in that the second metal (4, 7) occupies a volume lying in the range 10% to 40% of the total volume of metal.

5. A junction according to claim 14, characterized in taht the second metal occupies a volume lying in the range 10% to 20% of the total volume of metal.
